# EUROPEAN PATENT SPECIFICATION

(11) **EP 2 961 047 B1**
(45) Date of publication and mention of the grant of the patent: **10.04.2019**
(21) Application number: 13875894.1
(22) Date of filing: 25.02.2013
(51) Int. Cl.: H02M 1/00, H02M 1/08, H03K 17/0812, H02H 7/00, H02H 7/12

(54) **POWER CONVERSION DEVICE**
STROMWANDLER
DISPOSITIF DE CONVERSION D'ÉNERGIE

(43) Date of publication of application: 30.12.2015
(73) Proprietor: Hitachi, Ltd., Chiyoda-ku Tokyo 100-8280 (JP)
(72) Inventor: OGAWA, Kazutoshi, Tokyo 100-8280 (JP); ISHIKAWA, Katsumi, Tokyo 100-8280 (JP); HATANAKA, Ayumu, Tokyo 100-8280 (JP); KAGEYAMA, Hiroshi, Tokyo 100-8280 (JP); MASUDA, Toru, Tokyo 100-8280 (JP)
(74) Representative: MERH-IP Matias Erny Reichl Hoffmann Patentanwälte PartG mbB
(86) International application number: PCT/JP2013/054658
(87) International publication number: WO 2014/128951

(56) References cited:
- WO-A1-2007/116900
- JP-A- 2004 064 930
- JP-A- 2005 006 464
- JP-A- 2006 253 568
- JP-A- 2009 225 506
- JP-A- 2009 261 112
- US-A1- 2004 252 435
- US-A1- 2008 212 247
- HONG YAO LONG ET AL: "Investigation of Negative Gate Capacitance in MOS-Gated Power Devices", IEEE TRANSACTIONS ON ELECTRON DEVICES, IEEE SERVICE CENTER, PISACATAWAY, NJ, US, vol. 59, no. 12, 1 December 2012 (2012-12-01), pages 3464-3469, XP011472271, ISSN: 0018-9383, DOI: 10.1109/TED.2012.2219536

## Description

### Technical Field

The present invention relates to a power conversion device including a semiconductor element for performing switching operation for converting DC power into AC power or AC power into DC power.

### Background Art

A power conversion device has a function of converting DC power supplied from a DC power supply into AC power to be supplied to an AC electrical load such as a rotating electrical machine or a function of converting AC power generated by the rotating electrical machine into DC power to be supplied to the DC power supply. In order to achieve the conversion functions, the power conversion device includes an inverter circuit including a plurality of semiconductor elements and converts DC power into AC power or AC power into DC power by repeating conduction operation and interruption operation with the use of the semiconductor elements.

In the above power conversion device, a gate circuit for driving the semiconductor element includes a short-circuit protection circuit in order to prevent an excessive current from flowing to the semiconductor element when abnormality occurs in the circuit to thereby break the semiconductor element because of generation of heat or a switching surge voltage.

Conventionally, there is known a technology described in PTL 1 as a short-circuit protection technology. In this technology, a reference value is set to a minimum gate voltage value or more for causing a rated current to flow but less than a power supply voltage value of the gate circuit, and the reference value and a detected value of a gate voltage are compared to detect short circuit.

### Citation List

### Patent Literature

PTL 1: JP-A-2005-6464

US 2004/252435 A1 relates to a drive circuit that controls a switching device ON/OFF and a soft cutoff command circuit that gradually decreases the gate terminal voltage of the switching device when short circuit of the switching device is detected.

Hong Yao Long ET AL: "Investigation of Negative Gate Capacitance in MOS-Gated Power Devices", IEEE Transactions on Electron Devices, IEEE Service Center, Pisacataway, NJ, US, vol. 59, no. 12, 1 December 2012 relates to the analysis of gate capacitance of MOS-gated power devices during ON state.

### Summary of Invention

### Technical Problem

In recent years, in order to reduce an on-resistance of a semiconductor element for the purpose of energy saving, a switching element including a wide-gap semiconductor made of silicon carbide (SiC) or the like has been focused. The wide-gap semiconductor switching element has a large saturation current and a large transconductance, as compared with a conventional semiconductor silicon (Si) switching element.

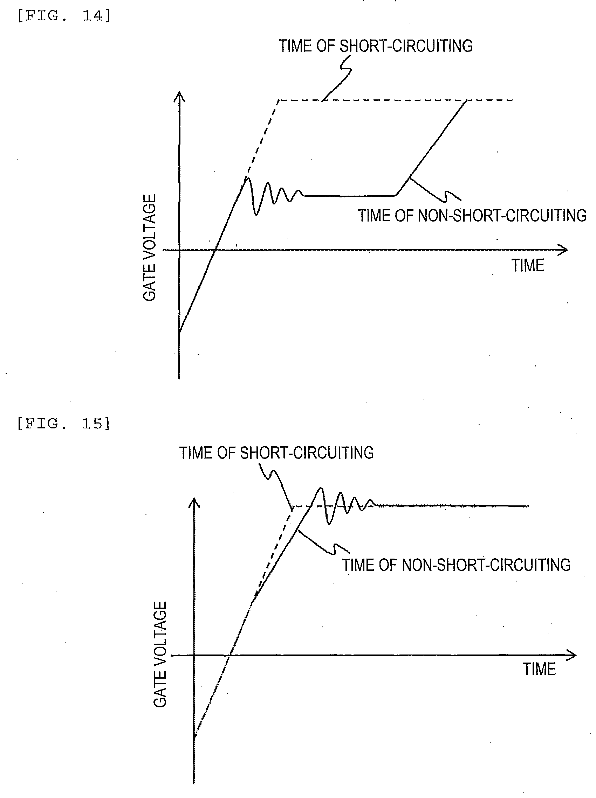

Fig. 14 shows gate voltage waveforms of a conventional Si switching element. Fig. 15 shows gate voltage waveforms of a wide-gap semiconductor switching element having a large transconductance.

In the conventional technology, in a period in which a difference between a gate voltage obtained when short circuit occurs and a gate voltage obtained when short circuit does not occur is large in Fig. 14, gate voltage detected values and a reference value are compared to detect short circuit. When short circuit does not occur, a period in which the gate voltage is constant is generated because of the Miller effect, and therefore, by setting the reference value to a minimum gate voltage or more for causing a rated current to flow but less than a power supply voltage value of the gate circuit, it is possible to detect short circuit.

Meanwhile, as shown in Fig. 15, because the wide-gap semiconductor switching element has a large transconductance, a period in which a gate voltage is constant because of the Miller effect is short and a difference between a gate voltage obtained when short circuit occurs and a gate voltage obtained when short circuit does not occur is small. Therefore, it is difficult to detect short circuit in some conventional technologies.

The invention has been made in view of the above problem, and therefore an object thereof is provide a power conversion device capable of securely detecting short circuit of a switching element having a large transconductance such as a wide-gap semiconductor switching element.

### Solution to Problem

In order to solve the above problem, the inventors of the invention focused on oscillation of a gate waveform obtained when short circuit occurs and a gate waveform obtained when short circuit does not occur. A feedback capacitance is discharged at the time of turning-on when short circuit does not occur, and an oscillating current is caused to flow due to the feedback capacitance and a parasitic inductance of a gate wiring. As a result, the gate voltage is oscillated. A power conversion device according to the invention is defined in the appended claims.

### Advantageous Effects of Invention

According to the invention, it is possible to accurately detect short circuit of a switching element having a large transconductance.

### Brief Description of Drawings

Fig. 1 shows a circuit configuration of a main part of a power conversion device which is Example 1 of the invention.
Fig. 2 shows gate voltage waveforms in Example 1.
Fig. 3 shows a circuit configuration of a main part of a power conversion device which is Example 2 of the invention.
Fig. 4 shows output waveforms of a differentiation circuit in Example 2.
Fig. 5 shows a circuit configuration of a main part of a power conversion device which is Example 3 of the invention.
Fig. 6 shows output waveforms of a differentiation circuit in Example 3.
Fig. 7 shows a circuit configuration of a main part of a power conversion device which is Example 4 of the invention.
Fig. 8 shows waveforms of a voltage between drain and source terminals in Example 4.
Fig. 9 shows a circuit configuration of a main part of a power conversion device which is Example 5 of the invention.
Fig. 10 shows drain current waveforms in Example 5.
Fig. 11 shows a circuit configuration of a main part of a power conversion device which is Example 6 of the invention.
Fig. 12 shows gate current waveforms in Example 6.
Fig. 13 shows a circuit configuration of a main part of a power conversion device which is Example 7 of the invention.
Fig. 14 shows gate voltage waveforms of a conventional Si switching element.
Fig. 15 shows gate voltage waveforms of a wide-gap semiconductor switching element.

### Description of Embodiments

### (Example 1)

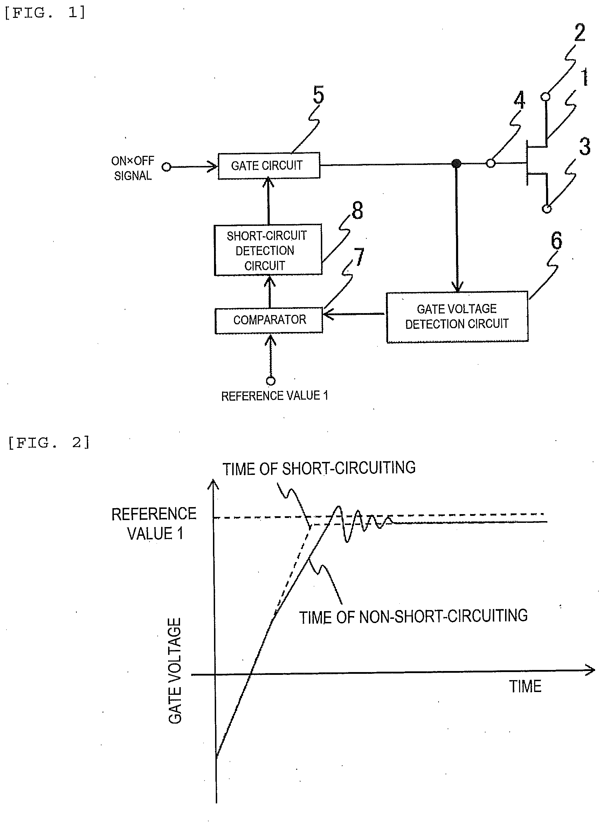

Fig. 1 shows a circuit configuration of a main part of a power conversion device which is Example 1 of the invention, and Fig. 2 shows gate voltage waveforms in this example.

The power conversion device of this example includes a semiconductor switching element 1 made of SiC as a constituent material, a gate circuit 5, a gate voltage detection circuit 6, a comparator 7, and a short-circuit detection circuit 8. The semiconductor switching element 1 includes a drain terminal 2, a source terminal 3, and a gate terminal 4. The gate circuit 5 for driving the semiconductor switching element 1 to turn on/off the semiconductor switching element 1 is connected between the gate terminal 4 and the source terminal 3.

The gate voltage detection circuit 6 detects a gate voltage that is a voltage between the gate terminal 4 and the source terminal 3. A gate voltage detected value outputted by the gate voltage detection circuit 6 and a preset reference value 1 are compared by the comparator 7.

A gate voltage obtained when short circuit does not occur is oscillated by resonance of a feedback capacitance and a gate wiring, and therefore a state in which the gate voltage detected value is larger than the reference value 1 and a state in which the gate voltage detected value is smaller than the reference value 1 are alternately repeated. The comparator 7 determines that the gate voltage detected value is larger than the reference value 1 or the gate voltage detected value is smaller than the reference value 1 or determines both thereof, and outputs a determination result.

Based on the determination result, within a preset time period in a period in which oscillation occurs, the short-circuit detection circuit 8 determines non-short-circuit in a case where a state in which the gate voltage is larger than the reference value 1, a state in which the gate voltage is smaller than the reference value 1, or both the states is/are detected a plurality of times and determines short circuit in a case where the states are not detected. The determination result of the short-circuit detection circuit 8 is inputted to the gate circuit 5, and the gate circuit 5 interrupts a current of the semiconductor switching element 1 when short circuit occurs and performs regular switching operation when short circuit does not occur.

Note that the semiconductor switching element is not limited to an SiC semiconductor switching element, and other wide-gap semiconductor switching elements such as a gallium nitride (GaN) semiconductor switching element maybe used (same applies to the following examples).

### (Example 2)

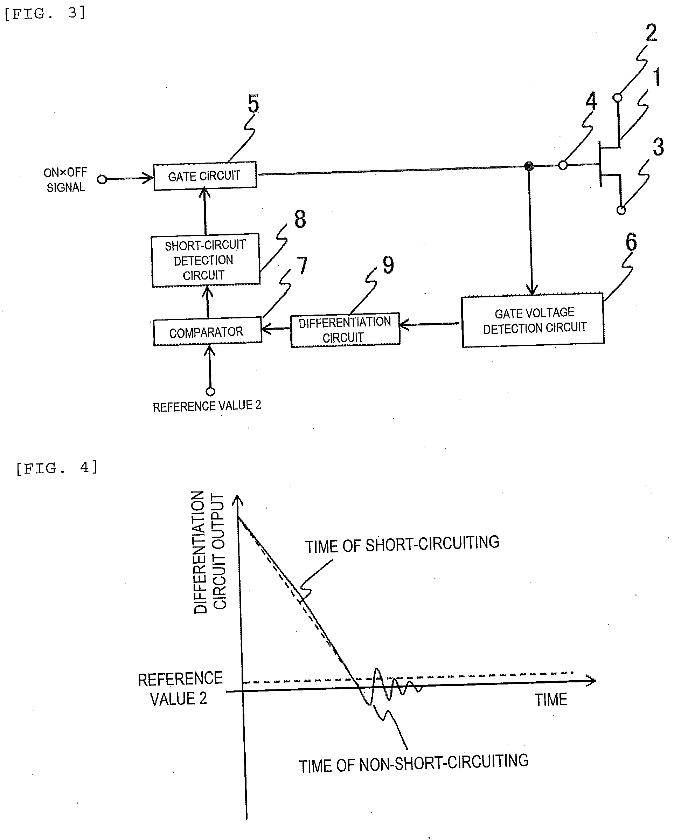

Fig. 3 shows a circuit configuration of a main part of a power conversion device which is Example 2 of the invention. In this example, a differentiation circuit for detecting a differential value of a gate voltage is provided, an amount of change of the gate voltage is detected, and short circuit is detected based on a detected value of the amount of change of the gate voltage.

Fig. 4 shows output waveforms of the differentiation circuit in this example. A gate voltage obtained when short circuit occurs becomes constant after reaching a power supply voltage of the gate circuit 5, and a differential value is 0. Therefore, the gate voltage maintains a value equal to or less than a reference value 2. Meanwhile, an output voltage of a differentiation circuit 9 obtained when short circuit does not occur is oscillated, and therefore a state in which the output voltage is larger than the reference value 2 and a state in which the output voltage is smaller than the reference value 2 are alternately repeated. By using the comparator 7 and the short-circuit detection circuit 8, in the same way as Example 1, non-short-circuit is determined in a case where a state in which a differential value of the gate voltage is larger than the reference value 2, a state in which the differential value of the gate voltage is smaller than the reference value 2, or both the states is/are detected a plurality of times and short circuit is determined in a case where the states are not detected.

The determination result of the short-circuit detection circuit 8 is inputted to the gate circuit 5, and the gate circuit 5 interrupts a current of the semiconductor switching element 1 when short circuit occurs and performs regular switching operation when short circuit does not occur. In a period in which oscillation occurs, non-short-circuit is determined in a case where a state in which the gate voltage is larger than the reference value 2 and a state in which the gate voltage is smaller than the reference value 2 are detected a plurality of times and short circuit is determined in a case where the states are not detected. The detection result of the short-circuit detection circuit 8 is inputted to the gate circuit 5, and the gate circuit 5 interrupts a current of the semiconductor switching element 1 when short circuit occurs and performs regular switching operation when short circuit does not occur.

### (Example 3)

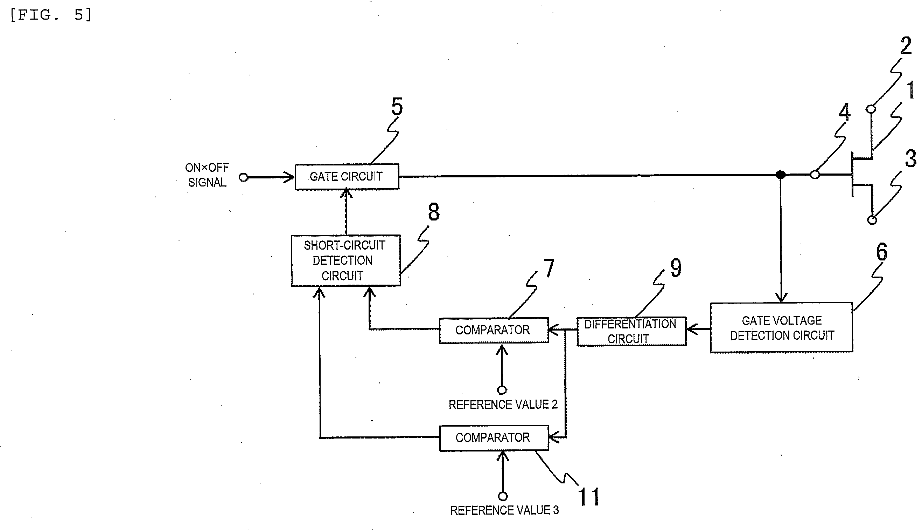

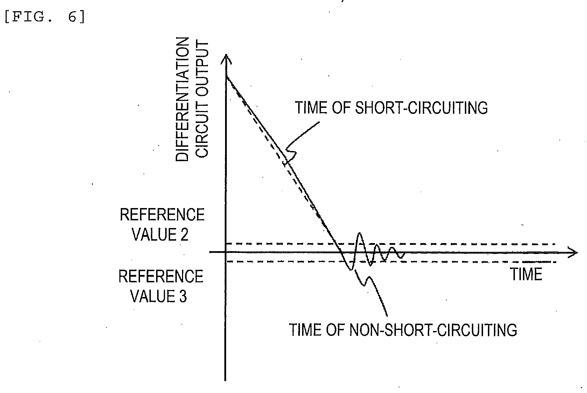

Fig. 5 shows a circuit configuration of a main part of a power conversion device which is Example 3 of the invention. Fig. 6 shows output waveforms of a differentiation circuit in this example.

A difference between this example and Example 2 is to set, as reference values, a positive-side reference value 2 of the gate voltage oscillation and a negative-side reference value 3 of the gate voltage oscillation. By setting the plurality of reference values, detection accuracy is improved and erroneous detection is reduced.

Note that, also in a case where a plurality of reference values are set in Example 1, the detection accuracy can be improved.

### (Example 4)

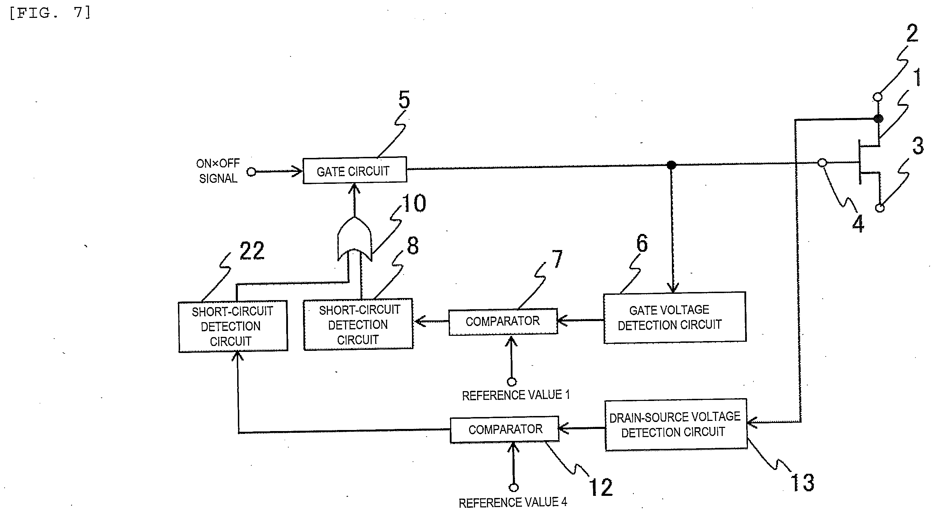

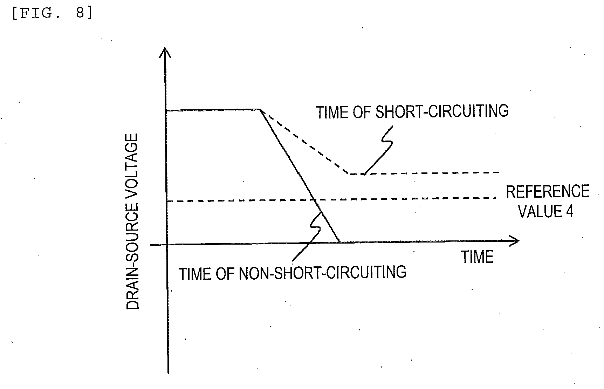

Fig. 7 shows a circuit configuration of a main part of a power conversion device which is Example 4 of the invention. Fig. 8 shows waveforms of a voltage between drain and source terminals in this example.

A voltage between a drain terminal and a source terminal obtained when short circuit occurs is slowly changed, as compared with a terminal voltage obtained when short circuit does not occur. After that, in a circuit including semiconductor elements in upper and lower arms, such as an inverter, a direct current voltage of the inverter is divided by the semiconductor elements of the upper and lower arms, and, because a general inverter includes the semiconductor elements having the same characteristic in the upper and lower arms, the direct current voltage maintains about a 1/2 voltage of an inverter voltage. In view of this, in this example, a drain-source voltage detection circuit 13 detects a voltage between the drain and source terminals after a certain time period, and a comparator 12 compares a detected value with a reference value 4. Based on a comparison result outputted by the comparator 12, a short-circuit detection circuit 22 determines non-short-circuit in a case where the detected value of the voltage between the drain and the source is smaller than the reference value 4 and determines short circuit in a case where the detected value is larger than the reference value 4.

In a case where an OR circuit 10 of determination results of the short-circuit detection circuit 8 in Example 1 and the short-circuit detection circuit 22 in this example determines that one of the short-circuit detection circuits determines short circuit, the gate circuit 5 interrupts a current of the semiconductor switching element 1. This improves short-circuit detection accuracy.

Note that the short-circuit detection accuracy is also improved by the short-circuit detection circuit 8 in Example 2 and the short-circuit detection circuit 22 in this example.

### (Example 5)

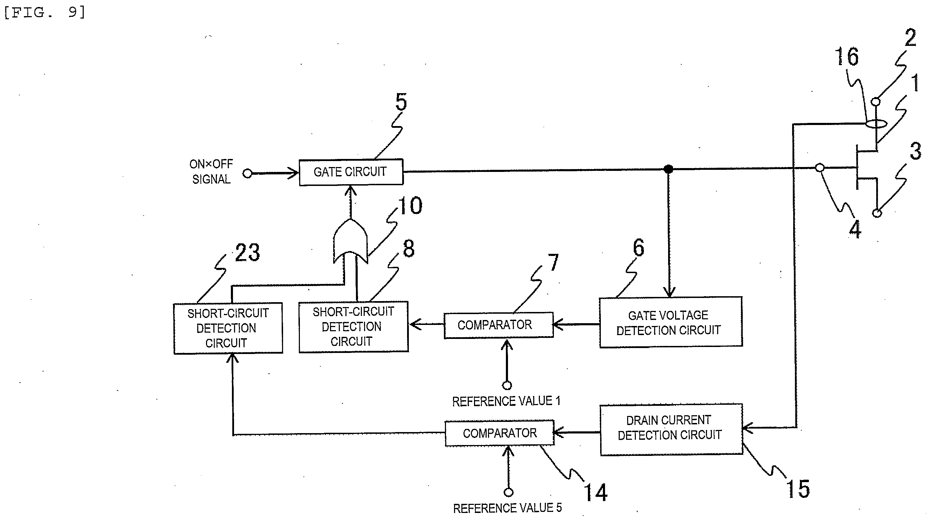

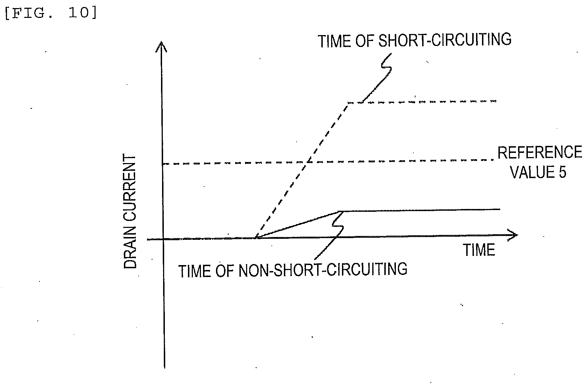

Fig. 9 shows a circuit configuration of a main part of a power conversion device which is Example 5 of the invention. Fig. 10 shows drain current waveforms in this example.

A drain current flowing when short circuit occurs is larger than a drain current flowing when short circuit does not occur and is increased to a saturation current of the semiconductor switching element. In view of this, in this example, a drain current detection circuit 15 detects a drain current after a certain time period, and a comparator 14 compares a detected value with a reference value 5. Based on a comparison result outputted by the comparator 14, a short-circuit detection circuit 23 determines non-short-circuit in a case where the drain current detected value is smaller than the reference value 5 and determines short circuit in a case where the drain current detected value is larger than the reference value 5.

In a case where the OR circuit 10 of the short-circuit detection circuit 8 in Example 1 and the short-circuit detection circuit 23 in this example determines that one of the short-circuit detection circuits determines short circuit, the gate circuit 5 interrupts a current of the semiconductor switching element 1. This improves the short-circuit detection accuracy.

Note that the short-circuit detection accuracy is also improved by the short-circuit detection circuit 8 in Example 2 and the short-circuit detection circuit 23 in this example.

### (Example 6)

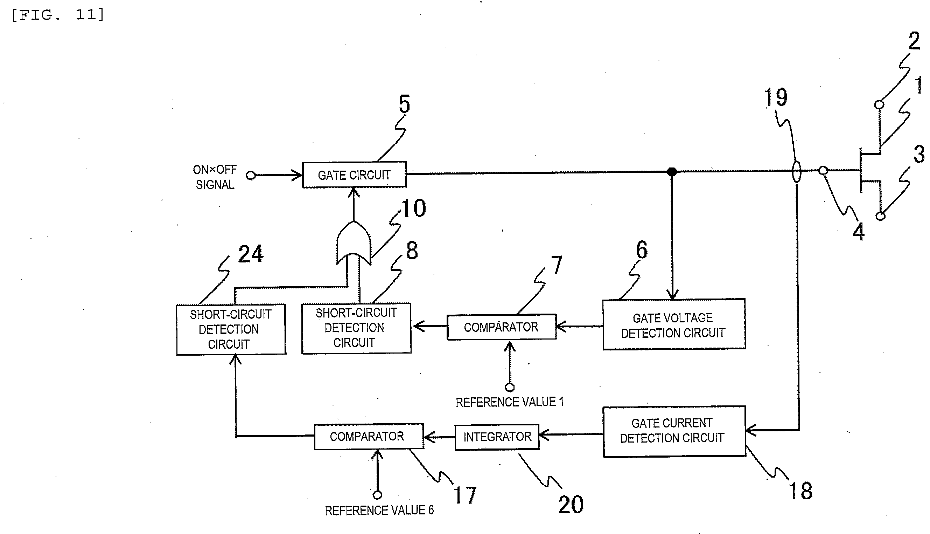

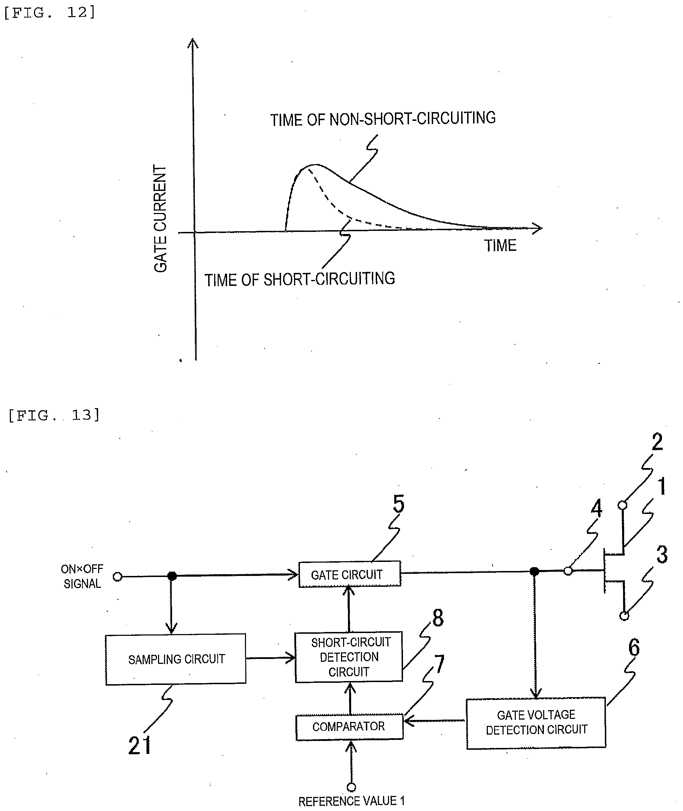

Fig. 11 shows a circuit configuration of a main part of a power conversion device which is Example 6 of the invention. Fig. 12 shows gate current waveforms in this example.

An electric charge amount supplied to a gate of the semiconductor switching element 1 when short circuit occurs is smaller than an electric charge amount supplied thereto when short circuit does not occur. This is because, when short circuit does not occur, a feedback capacitance is discharged and an electric charge amount supplied from the gate circuit 5 is increased accordingly. In view of this, in this example, a gate current detection circuit 18 detects a gate current of the semiconductor switching element 1, and an integrator 20 integrates detected values in a certain period and outputs an integrated value. The outputted integrated value is compared with a reference value 6 by a comparator 17. Based on a comparison result outputted by the comparator 17, a short-circuit detection circuit 24 determines short circuit in a case where the integrated value of the gate current is smaller than the reference value 6 and determines non-short-circuit in a case where the integrated value is larger than the reference value 6.

In a case where the OR circuit 10 of the short-circuit detection circuit 8 in Example 1 and the short-circuit detection circuit 24 in this example determines that one of the short-circuit detection circuits determines short circuit, the gate circuit 5 interrupts a current of the semiconductor switching element 1. This improves the short-circuit detection accuracy.

Note that the short-circuit detection accuracy is also improved by the short-circuit detection circuit 8 in Example 2 and the short-circuit detection circuit 24 in this example.

### (Example 7)

Fig. 13 shows a circuit configuration of a main part of a power conversion device which is Example 7 of the invention.

In order to reduce malfunction of the short-circuit detection circuit, setting an operation period in the detection circuit is effective. In view of this, in this example, in order to operate the short-circuit detection circuit 8 in a certain period immediately after turning-on in which short circuit occurs, a sampling circuit 21 is further provided in Example 1 to limit an operation time period of the short-circuit detection circuit 8. That is, a time period in which the short-circuit detection circuit 8 performs detection operation is set to be within a preset time period from a time at which a voltage between a gate terminal and a source terminal is increased.

Note that, the same effect can be also obtained by applying the sampling circuit 21 to the short-circuit detection circuit 8 in Fig. 3, the short-circuit detection circuit 22 in Fig. 7, the short-circuit detection circuit 23 in Fig. 9, or the short-circuit detection circuit 24 in Fig. 11. Reference Signs List

- 1: semiconductor element
- 2: drain terminal
- 3: source terminal
- 4: gate terminal
- 5: gate circuit
- 6: gate voltage detection circuit
- 7: comparator
- 8: short-circuit detection circuit
- 9: differentiation circuit
- 10: OR circuit
- 11: comparator
- 12: comparator
- 13: drain-source voltage detection circuit
- 14: comparator
- 15: drain current detection circuit
- 16: current sensor
- 17: comparator
- 18: gate current detection circuit
- 19: current sensor
- 20: integrator
- 21: sampling circuit
- 22: short-circuit detection circuit
- 23: short-circuit detection circuit
- 24: short-circuit detection circuit

## Claims

1. A power conversion device, comprising:
a semiconductor switching element (1) having a large transconductance such as wide-gap semiconductor switching element including a drain terminal (2), a source terminal (3), and a gate terminal (4);
a gate voltage detection circuit configured to detect a gate voltage between the gate terminal (4) and the source terminal (3);
a first comparator configured to compare a detected value of the gate voltage detected by the gate voltage detection circuit with a first reference value; and
a first short-circuit detection circuit configured to, on the basis of a comparison result of the first comparator, determine non-short-circuit in a case where a state in which the gate voltage is larger than the first reference value and a state in which the gate voltage is smaller than the first reference value alternately repeat, and both the states are detected a plurality of times within a preset time period in which gate voltage oscillation occurs.

2. A power conversion device, comprising:
a semiconductor switching element (1) having a large transconductance such as wide-gap semiconductor switching element including a drain terminal (2), a source terminal (3), and a gate terminal (4);
gate voltage detection circuit configured to detect a gate voltage between the gate terminal (4) and the source terminal (3) of the semiconductor switching element (1);
differentiation circuit configured to output a differential value of the gate voltage;
first comparator configured to compare the differential value of the gate voltage, the differential value being outputted by the differentiation circuit, with a first reference value; and
a first short-circuit detection circuit (8) configured to, on the basis of a comparison result of the first comparator, determining non-short-circuit in a case where a state in which the differential value of the gate voltage, the differential value being outputted by the differentiation circuit, is larger than the first reference value and a state in which the differential value is smaller than the first reference value alternately repeat, and both the states are detected a plurality of times in a period in which gate voltage oscillation occurs.

3. The power conversion device according to claim 1 or 2, wherein
as the first reference value, a plurality of first reference values are set.

4. The power conversion device according to claim 1 or 2, further comprising:
drain-source voltage detection circuit (13) configured to detect a voltage between the drain terminal (2) and the source terminal (3);
second comparator for comparing the voltage between the drain terminal (2) and the source terminal (3) detected by the drain-source voltage detection circuit with a terminal voltage reference value of the semiconductor switching element (1);
second short-circuit detection circuit (22) configured to detect short circuit on the basis of a comparison result of the second comparator; and
gate circuit configured to interrupt a current of the semiconductor switching element (1) in a case where one of the first short-circuit detection circuit [fig 5] and the second short-circuit detection circuit detects short circuit.

5. The power conversion device according to claim 1 or 2, further comprising:
drain current detection circuit configured to detect a drain current flowing through the semiconductor switching element (1);
second comparator for comparing a detected value of the drain current detected by the drain current detection circuit with a drain current reference value of the semiconductor switching element (1);
second short-circuit detection circuit configured to detect a short circuit on the basis of a comparison result of the second comparator; and
gate circuit configured to interrupt a current of the semiconductor switching element (1) in a case where one of the first short-circuit detection circuit and the second short-circuit detection circuit detects short circuit.

6. The power conversion device according to claim 1 or 2, comprising:
gate current detection circuit (18) configured to detect a current flowing through a gate of the semiconductor switching element (1);
integrator (20) for integrating a detected value of a gate current detected by the gate current detection circuit (18) and outputting an integrated value;
second comparator for comparing the integrated value outputted by the integrator (20) with a gate current reference value of the semiconductor switching element (1);
second short-circuit detection circuit configured to detect short circuit on the basis of a comparison result of the second comparator; and
gate circuit configured to interrupt a current of the semiconductor switching element (1) in a case where one of the first short-circuit detection circuit and the second short-circuit detection circuit detects short circuit.

7. The power conversion device according to any one of claims 1 to 6, wherein
an operation time period of the first short-circuit detection circuit is set to be within a preset time period from a time at which the voltage between the gate terminal (4) and the source terminal (3) is increased.

8. The power conversion device according to any one of claims 4 to 7, wherein
an operation time period of the second short-circuit detection circuit is set to be within a preset time period from a time at which the voltage between the gate terminal (4) and the source terminal (3) is increased.

9. The power conversion device according to any one of claims 1 to 8, wherein
the semiconductor switching element (1) is a wide-gap semiconductor switching element.

## Patentansprüche

1. Leistungsumsetzungsvorrichtung, die Folgendes umfasst:
ein Halbleiterschaltelement (1) mit einem großen Gegenwirkleitwert wie etwa ein Halbleiterschaltelement mit breiter Bandlücke, das einen Drain-Anschluss (2), einen Source-Anschluss (3) und einen Gate-Anschluss (4) enthält;
eine Gate-Spannungsdetektionsschaltung, die konfiguriert ist, eine Gate-Spannung zwischen dem Gate-Anschluss (4) und dem Source-Anschluss (3) zu detektieren;
einen ersten Komparator, der konfiguriert ist, einen detektierten Wert der Gate-Spannung, der durch die Gate-Spannungsdetektionsschaltung detektiert wird, mit einem ersten Referenzwert zu vergleichen; und
eine erste Kurzschlussdetektionsschaltung, die konfiguriert ist, auf der Grundlage eines Vergleichsergebnisses des ersten Komparators zu bestimmen, dass kein Kurzschluss vorliegt, wenn sich ein Zustand, bei dem die Gate-Spannung größer als der erste Referenzwert ist, und ein Zustand, bei dem die Gate-Spannung kleiner als der erste Referenzwert ist, abwechselnd wiederholen und beide Zustände mehrere Male innerhalb eines vorgegebenen Zeitraums, in dem eine Gate-Spannungsschwingung auftritt, detektiert werden.

2. Leistungsumsetzungsvorrichtung, die Folgendes umfasst:
ein Halbleiterschaltelement (1) mit einem großen Gegenwirkleitwert wie etwa ein Halbleiterschaltelement mit breiter Bandlücke, das einen Drain-Anschluss (2), einen Source-Anschluss (3) und einen Gate-Anschluss (4) enthält;
eine Gate-Spannungsdetektionsschaltung, die konfiguriert ist, eine Gate-Spannung zwischen dem Gate-Anschluss (4) und dem Source-Anschluss (3) des Halbleiterschaltelements (1) zu detektieren;
eine Differenzierschaltung, die konfiguriert ist, einen Differentialwert der Gate-Spannung auszugeben;
einen ersten Komparator, der konfiguriert ist, den Differentialwert der Gate-Spannung, wobei der Differentialwert durch die Differenzierschaltung ausgegeben wird, mit einem ersten Referenzwert zu vergleichen; und
eine erste Kurzschlussdetektionsschaltung (8), die konfiguriert ist, auf der Grundlage eines Vergleichsergebnisses des ersten Komparators zu bestimmen, dass kein Kurzschluss vorliegt, wenn sich ein Zustand, bei dem der Differentialwert der Gate-Spannung, wobei der Differentialwert durch die Differenzierschaltung ausgegeben wird, größer als der erste Referenzwert ist, und ein Zustand, bei dem der Differentialwert der Gate-Spannung kleiner als der erste Referenzwert ist, abwechselnd wiederholen und beide Zustände mehrere Male in einem Zeitraum, in dem eine Gate-Spannungsschwingung auftritt, detektiert werden.

3. Leistungsumsetzungsvorrichtung nach Anspruch 1 oder 2, wobei mehrere erste Referenzwerte als der erste Referenzwert eingestellt sind.

4. Leistungsumsetzungsvorrichtung nach Anspruch 1 oder 2, die ferner Folgendes umfasst:
eine Drain-Source-Spannungsdetektionsschaltung (13), die konfiguriert ist, eine Spannung zwischen dem Drain-Anschluss (2) und dem Source-Anschluss (3) zu detektieren;
einen zweiten Komparator zum Vergleichen der Spannung zwischen dem Drain-Anschluss (2) und dem Source-Anschluss (3), die durch die Drain-Source-Spannungsdetektionsschaltung detektiert wird, mit einem Anschlussspannungs-Referenzwert des Halbleiterschaltelements (1);
eine zweite Kurzschlussdetektionsschaltung (22), die konfiguriert ist, auf der Grundlage eines Vergleichsergebnisses des zweiten Komparators einen Kurzschluss zu detektieren; und
eine Gate-Schaltung, die konfiguriert ist, einen Strom des Halbleiterschaltelements (1) zu unterbrechen, wenn entweder die erste Kurzschlussdetektionsschaltung [Fig. 5] oder die zweite Kurzschlussdetektionsschaltung einen Kurzschluss detektiert.

5. Leistungsumsetzungsvorrichtung nach Anspruch 1 oder 2, die ferner Folgendes umfasst:
eine Drain-Stromdetektionsschaltung, die konfiguriert ist, einen Drain-Strom zu detektieren, der durch das Halbleiterschaltelement (1) fließt;
einen zweiten Komparator zum Vergleichen eines detektierten Wertes des Drain-Stroms, der durch die Drain-Stromdetektionsschaltung detektiert wird, mit einem Drain-Stromreferenzwert des Halbleiterschaltelements (1);
eine zweite Kurzschlussdetektionsschaltung, die konfiguriert ist, auf der Grundlage eines Vergleichsergebnisses des zweiten Komparators einen Kurzschluss zu detektieren; und
eine Gate-Schaltung, die konfiguriert ist, einen Strom des Halbleiterschaltelements (1) zu unterbrechen, wenn entweder die erste Kurzschlussdetektionsschaltung oder die zweite Kurzschlussdetektionsschaltung einen Kurzschluss detektiert.

6. Leistungsumsetzungsvorrichtung nach Anspruch 1 oder 2, die Folgendes umfasst:
eine Gate-Stromdetektionsschaltung (18), die konfiguriert ist, einen Strom zu detektieren, der durch ein Gate des Halbleiterschaltelements (1) fließt;
einen Integrator (20) zum Integrieren eines detektierten Wertes eines Gate-Stroms, der durch die Gate-Stromdetektionsschaltung (18) detektiert wird, und zum Ausgeben eines integrierten Wertes;
einen zweiten Komparator zum Vergleichen des integrierten Wertes, der durch den Integrator (20) ausgegeben wird, mit einem Gate-Stromreferenzwert des Halbleiterschaltelements (1);
eine zweite Kurzschlussdetektionsschaltung, die konfiguriert ist, auf der Grundlage eines Vergleichsergebnisses des zweiten Komparators einen Kurzschluss zu detektieren; und
eine Gate-Schaltung, die konfiguriert ist, einen Strom des Halbleiterschaltelements (1) zu unterbrechen, wenn entweder die erste Kurzschlussdetektionsschaltung oder die zweite Kurzschlussdetektionsschaltung einen Kurzschluss detektiert.

7. Leistungsumsetzungsvorrichtung nach einem der Ansprüche 1 bis 6, wobei
ein Betriebszeitraum der ersten Kurzschlussdetektionsschaltung derart eingestellt ist, dass er innerhalb eines vorgegebenen Zeitraums von einer Zeit an liegt, zu der die Spannung zwischen dem Gate-Anschluss (4) und dem Source-Anschluss (3) erhöht wird.

8. Leistungsumsetzungsvorrichtung nach einem der Ansprüche 4 bis 7, wobei
ein Betriebszeitraum der zweiten Kurzschlussdetektionsschaltung derart eingestellt ist, dass er innerhalb eines vorgegebenen Zeitraums von einer Zeit an liegt, zu der die Spannung zwischen dem Gate-Anschluss (4) und dem Source-Anschluss (3) erhöht wird.

9. Leistungsumsetzungsvorrichtung nach einem der Ansprüche 1 bis 8, wobei
das Halbleiterschaltelement (1) ein Halbleiterschaltelement mit breiter Bandlücke ist.

## Revendications

1. Dispositif de conversion d'énergie, comprenant :
un élément de commutation à semi-conducteur (1) ayant une grande transconductance, comme un élément de commutation à semi-conducteur à large saut de bande incluant une borne de drain (2), une borne de source (3), et une borne de grille (4) ;
un circuit de détection de tension de grille configuré pour détecter une tension de grille entre la borne de grille (4) et la borne de source (3) ;
un premier comparateur configuré pour comparer une valeur détectée de la tension de grille détectée par le circuit de détection de tension de grille avec une première valeur de référence ; et
un premier circuit de détection de court-circuit configuré pour, sur la base d'un résultat de comparaison du premier comparateur, déterminer l'absence de court-circuit dans un cas où un état dans lequel la tension de grille est plus élevée que la première valeur de référence et un état dans lequel la tension de grille est plus faible que la première valeur de référence se répètent en alternance, et les deux états sont détectés une pluralité de fois à l'intérieur d'une période temporelle préétablie dans laquelle se produit une oscillation de la tension de grille.

2. Dispositif de conversion d'énergie, comprenant :
un élément de commutation à semi-conducteur (1) ayant une grande transconductance, comme un élément de commutation à semi-conducteur à large saut de bande incluant une borne de drain (2), une borne de source (3), et une borne de grille (4) ;
un circuit de détection de tension de grille configuré pour détecter une tension de grille entre la borne de grille (4) et la borne de source (3) de l'élément de commutation à semi-conducteur (1) ;
un circuit de différenciation configuré pour délivrer une valeur différentielle de la tension de grille ;
un premier comparateur configuré pour comparer la valeur différentielle de la tension de grille, la valeur différentielle étant délivrée par le circuit de différenciation, avec une première valeur de référence ; et
un premier circuit de détection de court-circuit (8) configuré pour, sur la base d'un résultat de comparaison du premier comparateur, déterminer une absence de court-circuit dans un cas où un état dans lequel la valeur différentielle de la tension de grille, la valeur différentielle étant délivrée par le circuit de différenciation, est plus élevée que la première valeur de référence et un état dans lequel la valeur différentielle est plus petite que la première valeur de référence se répètent en alternance, et les deux états sont détectés une pluralité de fois dans une période dans laquelle se produit une oscillation de la tension de grille.

3. Dispositif de conversion d'énergie selon la revendication 1 ou 2, dans lequel une pluralité de premières valeurs de référence sont fixées à titre de première valeur de référence.

4. Dispositif de conversion d'énergie selon la revendication 1 ou 2, comprenant en outre :
un circuit de détection de tension drain/source (13) configuré pour détecter une tension entre la borne de drain (2) et la borne de source (3) ;
un second comparateur pour comparer la tension entre la borne de drain (2) et la borne de source (3) détectée par le circuit de détection de tension drain/source avec une valeur de référence de la tension aux bornes de l'élément de commutation à semi-conducteurs (1) ;
un second circuit de détection de court-circuit (22) configuré pour détecter un court-circuit sur la base d'un résultat de comparaison du second comparateur ; et
un circuit de grille configuré pour interrompre un courant de l'élément de commutation à semi-conducteur (1) dans un cas où un circuit parmi le premier circuit de détection de court-circuit [figure 5] et le second circuit de détection de court-circuit détecte un court-circuit.

5. Dispositif de conversion d'énergie selon la revendication 1 ou 2, comprenant en outre :
un circuit de détection de courant de drain configuré pour détecter un courant de drain qui s'écoule à travers l'élément de commutation à semi-conducteur (1) ;
un second comparateur pour comparer une valeur détectée du courant de drain détecté par le circuit de détection de courant de drain avec une valeur de référence du courant de drain de l'élément de commutation à semi-conducteur (1) ;
un second circuit de détection de court-circuit configuré pour détecter un court-circuit sur la base d'un résultat de comparaison du second comparateur ; et
un circuit de grille configuré pour interrompre un courant de l'élément de commutation à semi-conducteur (1) dans un cas où un circuit parmi le premier circuit de détection de court-circuit et le second circuit de détection de court-circuit détecte un court-circuit.

6. Dispositif de conversion d'énergie selon la revendication 1 ou 2, comprenant :
un circuit de détection de courant de grille (18) configuré pour détecter un courant qui s'écoule à travers une grille de l'élément de commutation à semi-conducteur (1) ;
un intégrateur (20) pour intégrer une valeur détectée d'un courant de grille détecté par le circuit de détection de courant de grille (18) et délivrer une valeur intégrée ;
un second comparateur pour comparer la valeur intégrée délivrée par l'intégrateur (20) avec une valeur de référence de courant de grille de l'élément de commutation à semi-conducteur (1) ;
un second circuit de détection de court-circuit configuré pour détecter un court-circuit sur la base d'un résultat de comparaison du second comparateur ; et
un circuit de grille configuré pour interrompre un courant de l'élément de commutation à semi-conducteur (1) dans un cas où un circuit parmi le premier circuit de détection de court-circuit et le second circuit de détection de court-circuit détecte un court-circuit.

7. Dispositif de conversion d'énergie selon l'une quelconque des revendications 1 à 6, dans lequel
une période temporelle de fonctionnement du premier circuit de détection de court-circuit est fixée pour tomber à l'intérieur d'une période temporelle préétablie à partir d'un instant auquel la tension entre la borne de grille (4) et la borne de source (3) est augmentée.

8. Dispositif de conversion d'énergie selon l'une quelconque des revendications 4 à 7, dans lequel
une période temporelle de fonctionnement du second circuit de détection de court-circuit est fixée pour tomber à l'intérieur d'une période temporelle préétablie à partir d'un instant auquel la tension entre la borne de grille (4) et la borne de source (3) est augmentée.

9. Dispositif de conversion d'énergie selon l'une quelconque des revendications 1 à 8, dans lequel
l'élément de commutation à semi-conducteur (1) est un élément de commutation à semi-conducteur à large saut de bande.
